(19) Europäisches Patentamt / European Patent Office / Office européen des brevets

(11) **EP 2 853 033 B1**

(12) **EUROPEAN PATENT SPECIFICATION**

(45) Date of publication and mention
of the grant of the patent:
**27.07.2022 Bulletin 2022/30**

(21) Application number: **13813646.0**

(22) Date of filing: **27.06.2013**

(51) International Patent Classification (IPC):
**H04N 19/91** (2014.01)    **H04N 19/82** (2014.01)
**H04N 19/70** (2014.01)    **H04N 19/463** (2014.01)

(52) Cooperative Patent Classification (CPC):
**H04N 19/463; H04N 19/70; H04N 19/82;
H04N 19/91**

(86) International application number:
**PCT/US2013/048353**

(87) International publication number:
**WO 2014/008109 (09.01.2014 Gazette 2014/02)**

(54) **DECOUPLING ENHANCEMENTS IN SAMPLE ADAPTIVE OFFSET (SAO) FOR HIGH EFFICIENCY VIDEO ENCODER (HEVC)**

ENTKOPPLUNGSVERBESSERUNGEN BEI SAMPLE-ADAPTIVE-OFFSET (SAO) FÜR HOCHEFFIZIENTE VIDEOKODIERER (HEVC)

AMÉLIORATIONS APPORTÉES AU DÉCOUPLAGE DANS UN DÉCALAGE ADAPTATIF D'ÉCHANTILLON (SAO) POUR CODEUR VIDÉO HAUT RENDEMENT (HEVC)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **02.07.2012   US 201261667331 P
02.07.2012   US 201261667321 P
11.07.2012   US 201261670454 P
13.03.2013   US 201313801553**

(43) Date of publication of application:
**01.04.2015 Bulletin 2015/14**

(60) Divisional application:
**17197373.8 / 3 301 935
19191334.2 / 3 591 976
21184850.2 / 3 917 148
21184852.8 / 3 917 149
21184861.9 / 3 917 150**

(73) Proprietor: **Sony Group Corporation**
**Tokyo 108-0075 (JP)**

(72) Inventors:
• **TABATABAI, Ali**
**Cupertino, CA 95014 (US)**
• **XU, Jun**
**Sunnyvale, CA 94086 (US)**

(74) Representative: **D Young & Co LLP**
**120 Holborn**
**London EC1N 2DY (GB)**

(56) References cited:
**US-A1- 2012 082 241**

• **MAANI (SONY) E ET AL: "SAO Type Coding Simplification", 9. JCT-VC MEETING; 100. MPEG MEETING; 27-4-2012 - 7-5-2012; GENEVA; (JOINT COLLABORATIVE TEAM ON VIDEO CODING OF ISO/IEC JTC1/SC29/WG11 AND ITU-T SG.16 ); URL: HTTP://WFTP3.ITU.INT/AV-ARCH/JCTVC-SITE/,, no. JCTVC-I0246, 17 April 2012 (2012-04-17), XP030112009,**
• **SOLE J ET AL: "AhG6: Bypass bins grouping in SAO", 10. JCT-VC MEETING; 101. MPEG MEETING; 11-7-2012 - 20-7-2012; STOCKHOLM; (JOINT COLLABORATIVE TEAM ON VIDEO CODING OF ISO/IEC JTC1/SC29/WG11 AND ITU-T SG.16 ); URL: HTTP://WFTP3.ITU.INT/AV-ARCH/JCTVC-SITE/,, no. JCTVC-J0054, 26 June 2012 (2012-06-26) , XP030112416,**

- MINEZAWA A ET AL: "Non-CE1: Improved edge offset coding for SAO", 9. JCT-VC MEETING; 100. MPEG MEETING; 27-4-2012 - 7-5-2012; GENEVA; (JOINT COLLABORATIVE TEAM ON VIDEO CODING OF ISO/IEC JTC1/SC29/WG11 AND ITU-T SG.16 ); URL: HTTP://WFTP3.ITU.INT/AV-ARCH/JCTVC-SITE/,, no. JCTVC-I0066, 16 April 2012 (2012-04-16), XP030111829,
- BICI O ET AL: "Context reduction for merge index coding", 8. JCT-VC MEETING; 99. MPEG MEETING; 1-2-2012 - 10-2-2012; SAN JOSE; (JOINT COLLABORATIVE TEAM ON VIDEO CODING OF ISO/IEC JTC1/SC29/WG11 AND ITU-T SG.16 ); URL: HTTP://WFTP3.ITU.INT/AV-ARCH/JCTVC-SITE/,, no. JCTVC-H0251, 20 January 2012 (2012-01-20), XP030111278,
- WIEGAND ET AL.: 'WD3: Working Draft 3 of High-Efficiency Video Coding.' 2011, XP030009014 Retrieved from the Internet: <URL:http://phenix.it-sudparis.eu/jcUdoc end_user/current document.php?id=2471> [retrieved on 2013-10-04]
- PALOMINO.: 'WD3: danielpalomino/intra-decision/ cfg / encoder intra.cfg.' 04 October 2011, XP055180177 Retrieved from the Internet: <URL:https://github.com/danielpalomino/intr a-decision/blob/master/cfg/encoder intra.cfg> [retrieved on 2013-10-04]
- SZE ET AL.: 'Reduction in context coded bins for ref idx and cu_qp delta.' 02 July 2012, XP030111967 Retrieved from the Internet: <URL:http://phenix.int-evry.fr/jct/doc end_user/current document.php?id=5462> [retrieved on 2013-10-04]

**Description**

BACKGROUND OF THE INVENTION

1. Field of the Invention

This invention pertains generally to video encoding and decoding, and more particularly to enhanced signaling improvements to Sample Adaptive Offsets (SAO) within high-efficiency video coding (HEVC) systems.

2. Description of Related Art

A significant and ongoing demand continues for high efficiency video coding (HEVC) toward more optimal and scalable video compression. The Joint Collaborative Team on Video Coding (JCT-VC) of ITU-T and ISO/IEC MPEG continues enhancing a high efficiency video coding (HEVC) standard.

In HEVC, the frames are divided into coding tree blocks (CTBs) that can be further subdivided into coding units (CUs), such as using quadtree segmentation. A coding unit (CU) may have variable sizes depending on video content toward achieving a desired coding efficiency. CUs typically include a luminance component Y and two chroma components, U and V. The size of U and V components relate to the number of samples, and can be the same or different from that of the Y component, as depends upon the video sampling format. The CUs can be further subdivided into prediction unit (PU) partitions during intra-prediction and inter-prediction as well as transform units (TUs) defined for transform and quantization. Transform units (TU) generally refer to a block of residual data to which a transform is applied when generating transform coefficients.

HEVC introduces new elements over current video coding systems, such as H.264/AVC, and similar codecs. For example, although HEVC still involves motion compensated inter predictions, transforms, and entropy coding, it utilizes either arithmetic coding or variable length coding. In addition, following the deblocking filter is a sample adaptive offset (SAO) filter. The SAO filter unit operates once for each pixel in the CTB. For each CTB, a filter type and offset values are coded in the bitstream. There are two types of filters, specifically, edge and band filters. The band of a given sample is simply the upper 5 bits of its value. Then a band index is transmitted, along with the four offsets, that identifies four adjacent bands. So if the band index is 4, it means bands 4, 5, 6 and 7. If a pixel falls into one of these bands, the corresponding offset is added to it. In an edge filter an edge mode is transmitted (e.g., 0, 90, 45, 135 degrees). The offsets and filter modes are picked by the encoder toward making the CTB more closely match the source image.

The SAO filter considers the entire frame as a hierarchical quadtree. Quadrants in this quadtree are activated by the SAO transmitting syntax values which each represent an intensity band of pixel values referred to as band offset (BO) or the difference compared to neighboring pixel intensities referred to as edge offset (EO). For each type in SAO (BO and EO), transmitted offset values referred to as SAO offset are added to the corresponding pixels.

For example, HEVC working document 7 (WD 7) provides SAO on / off, 4 Edge Offset (EO) classes, and one Band Offset (BO). These SAO types are signaled to the decoder using a Unary code with two contexts for context-adaptive binary arithmetic coding (CABAC) coding, one on the first bin and one for the rest of the bins. In addition, for the BO type, band position is transmitted using FL codes. Context coded bins and by-pass coded bins are interleaved, which limit the CABAC engine throughput.

A previously proposed arrangement is disclosed by Maani et al: "SAO Type Coding Simplification", JCTVC-I0246, April 2012

The present invention provides forms of type decoupling which improve the efficiency of SAO signaling within a video coding system.

BRIEF SUMMARY OF THE INVENTION

The invention is defined by the claims.

The present invention provides an improved mechanisms for enhanced signaling of SAO parameters exemplified in three primary aspects. The inventive apparatus changes SAO type coding in terms of syntax and binarization, provides new context modeling, and resolves interleaving of context coded bins and by-pass coded bins.

In a first aspect (embodiment A), which is not covered by the claimed invention, SAO on / off is enhanced by decoupling it with SAO on / off flags being jointly encoded for all color components. The lookup table for lcu_sao_enable_idx is removed, with an equation utilized instead. Truncated unary binarization is utilized for the code index. Then only the first bin is context coded and the other bins are encoded using by-pass mode.

The second aspect (embodiment B), which is not covered by the claimed invention, is similar to embodiment A, but applicable to JCTVC-J0268. SAO type is encoded with single context. Only the first bin is context coded with one dedicated context, while the remaining bins are encoded in bypass mode.

The third aspect (embodiment C), provides separate signaling for SAO on / off, SAO types BO and EO, and for BO and EO side information (classes or band position). SAO type is binarized by truncated unary and encoded with only one context for the first bin. EO classes are encoded using fixed length code and by-pass mode. Both context coded bins and by-pass coded bins are grouped to improve throughput of CABAC.

Further aspects of the invention will be brought out in the following portions of the specification, wherein the detailed description is for the purpose of fully disclosing preferred embodiments of the invention without placing limitations thereon.

BRIEF DESCRIPTION OF THE SEVERAL VIEWS OF THE DRAWING(S)

The invention will be more fully understood by reference to the following drawings which are for illustrative purposes only:

FIG. 1 is a schematic of a video encoder according to embodiments of the present invention.
FIG. 2 is a schematic of a video decoder according to embodiments of the present invention.
FIG. 3 is a flow diagram of a type first SAO (embodiment C) syntax according to an embodiment of the present invention.

DETAILED DESCRIPTION OF THE INVENTION

The inventive apparatus and method enhances SAO operation in HEVC encoders and decoders, while overcoming shortcomings of existing and proposed SAO signaling methods. In the developing High Efficiency Video Coding (HEVC) standard test model HM 7.0, each color component has one sample adaptive offset (SAO) type including on/off, EO types, and BO. Yet, it can be desirable to enhance SAO parameter signaling.

**Introduction**

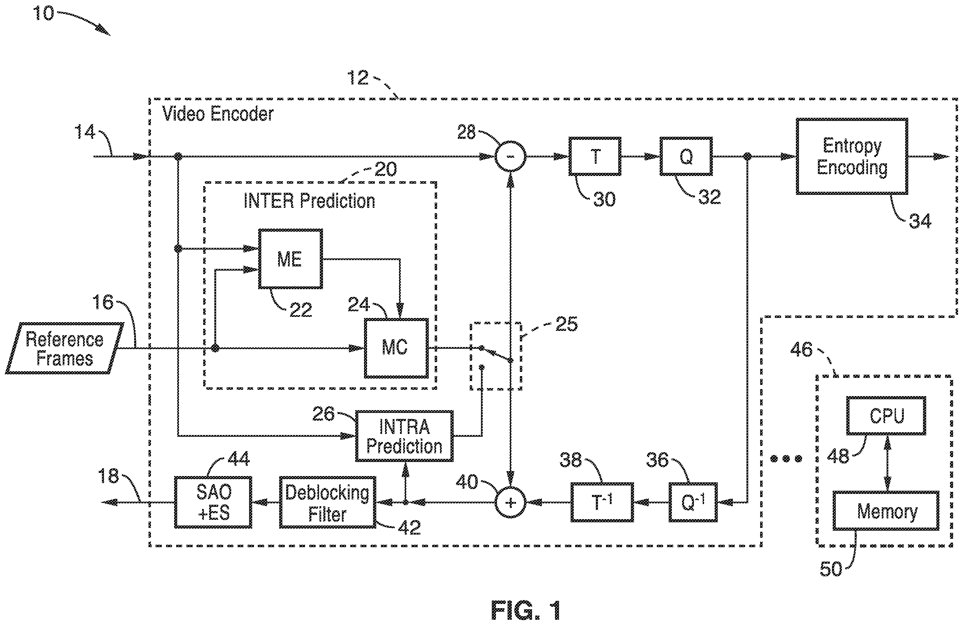

FIG. 1 illustrates an example embodiment of a coding apparatus comprising an encoder 10 according to the invention with enhanced sample adaptive offsets (SAO).

The encoder 10 is shown with encoding elements 12 executed by a computing means 46 exemplified with one or more processors 48, along with one or more memory devices 50. It will be appreciated that elements of the present invention can be implemented as programming stored on a media, which can be accessed for execution by a CPU for an encoder and / or decoder.

In the example, video frame input 14 is shown along with reference frames 16 and frame output 18. Inter-prediction 20 is depicted with motion estimation (ME) 22 and motion compensation (MC) 24. Intra-prediction 26 is shown with switching 25 depicted between inter-prediction and intra-prediction. A sum junction 28 is shown with output to a forward transform 30 which is performed based on the predictions to generate transform coefficients of residual data. Quantization of the transform coefficients is performed at quantization stage 32, which is followed by entropy encoding 34. Inverse quantization 36 and inverse transform 38 operations are shown coupled to a summing junction 40.

Output of summing junction 40, is a decoded video signal which is received by a deblocking filter 42, the Sample Adaptive Offset (SAO) filter with inventive enhanced signaling (+ES) 44 to produce an output 18. The enhanced signaling can be provided according to the present invention utilizing any of three embodiments which are described in detail in the following sections.

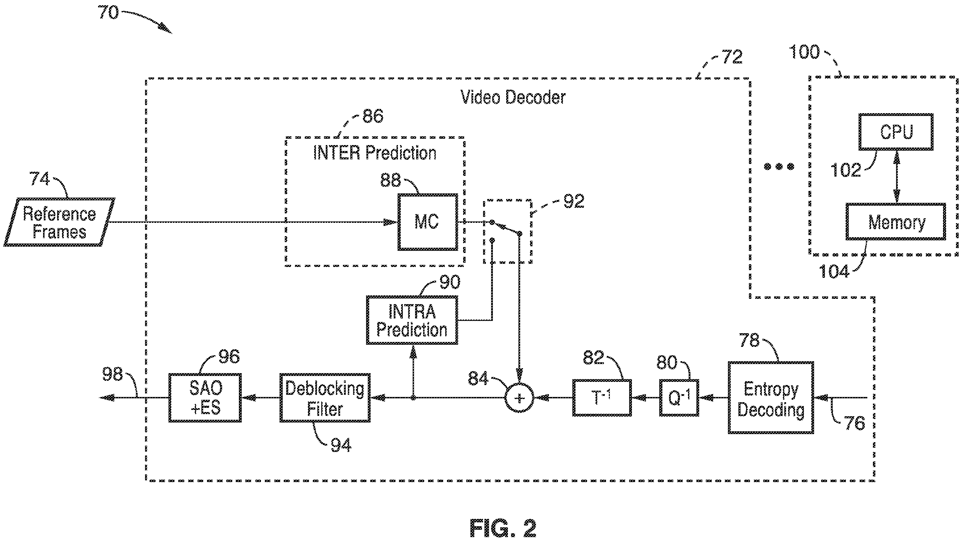

FIG. 2 illustrates an example embodiment 70 of a decoder, shown with process blocks 72 and an associated processing means 102. It will be noted that the decoder is substantially a subset of the elements contained in encoder 10 of FIG. 1, operating on reference frames 74 and outputting video signal 100. The decoder blocks receive an encoded video signal 76 which is processed through entropy decoder 78, inverse quantization 80, inverse transform 82, and summing 84 between the inverse transform 82 output and the selection 92 between inter-prediction 86 shown with motion compensation 88 and a separate intra-prediction block 90. Output from summing junction 84 is received by a deblocking filter 94, followed by SAO module with inventive enhanced signaling (+ES) 96 to produce a video output 98.

It should be appreciated that the decoder can be implemented with a processing means 100 which comprises at least one processing device 102 and at least one memory 104 for executing programming associated with the decoding. In addition, it will be noted that elements of the present invention can be implemented as programming stored on a media, wherein said media can be accessed for execution by processing device (CPU) 102.

It will be recognized that elements of the present invention 10 and 70 are implemented for execution by a processing means 46 and 100, such as in response to programming resident in memory 50 and 104 which is executable on computer processor (CPU) 48 and 102. In addition, it will be appreciated that elements of the present invention can be implemented as programming stored on a media, wherein said media can be accessed for execution by CPU 48 and / or 102.

It should also be appreciated that the above programming is executable from the memory which is a tangible (physical) computer readable media that is non-transitory in that it does not merely constitute a transitory propagating signal, but is actually capable of retaining programming, such as within any desired form and number of static or dynamic memory devices. These memory devices need not be implemented to maintain data under all conditions (e.g., power fail) to be considered herein as non-transitory media.

## A. Embodiment A: Simplification of JCTVC-I0193.

The enhancement to the decoupling of SAO on / off and types can be performed in two different variations. In the first two variations SAO on / off are decoupled from SAO type coding, with SAO on / off flags being encoded jointly for all color components.

In this first variation, a simplified JCTVC-I0193 embodiment is provided which combines SAO flags with the following changes. (1) The look-up table (e.g., Table 1) is replaced and a code index is generated with an equation as follows:

$$\text{code index} = (\text{lcu\_sao\_enable\_flagCr}<<2) +$$
$$(\text{lcu\_sao\_enable\_flagCb}<<1) +$$
$$\text{lcu\_sao\_enable\_flagY}$$

In the above equation, truncated unary binarization is utilized for the code index. Only the first bin is context coded and other bins are encoded in the by-pass mode.

The type coding, seen in Table 2, and offset coding then remain the same as JCTVC-10193 extended to HM7.0.

Table 3 illustrates an example of slice data syntax.

Table 4 illustrates SAO parameter syntax with descriptor.

Table 5 illustrates type information for BO and EO. The value sao_band_position [ cldx ][ rx ][ ry ] indicates the displacement of the band offset of the pixel range when sao_type_idx [ cldx ][ rx ][ ry ] is equal to 4. The value sao_offset_sign[ cldx ][ rx ][ ry ][ i ] specifies the sign of sao_offset[ cldx ][ rx ][ ry ][ i ] when sao_type_index is equal to 4. The variable offset sign is derived as follows. If sao_type_idx [ cldx ][ rx ][ ry ] is less than 4 and i is larger than 1, offset sign is set to -1. Otherwise (sao_type_idx [ cldx ][ rx ][ ry ] is equal to 4 or i is less than 2), offset sign is set to 1.

Table 6 illustrates how lcu_sao_enable_idx specifies the LCU SAO enable flag values of three color components.

## B. Embodiment B: JCTVC-J0268 + Simplification of JCTVC-I0193.

In this embodiment, the simplified solution above is combined with the solution from JCTVC-J0268 on SAO signaling to provide an enhanced signaling structure for SAO. This results in a small change in the SAO type due to the decoupling of SAO on / off in simplifying JCTVC-I0193 described above. The SAO signaling of the combined solution is listed in order as follows: (1) First, the SAO on/off index for three on/off flags from all color components is signaled. The index is binarized using truncated unary code. Only the first bin is context coded with one dedicated context. The rest of the bins are encoded in by-pass mode. For each color component, if SAO is enabled, then the process moves to the next step (step 2); otherwise, finish SAO signaling. (2) SAO type as shown in Table 7 is encoded with one context. (3) Offsets including absolute values and signs are encoded as HM7.0 does. (4) If the SAO type is EO, then EO classes are signaled using sao_eo_class as shown in Table 8, which is encoded by FLC with by-pass. (5) If SAO type is BO, then band positions are signaled as HM7.0 does.

Table 9 illustrates a specification of slice data syntax.

Table 10 provides an example of SAO parameter syntax for this embodiment.

Table 11 illustrates specifying SAO type.

Table 12 illustrates how lcu_sao_enable_idx indicates the LcuSaoEnableFlag values of three color components.

Table 13 exemplifies the parameter sao_eo_class[ cldx ][ rx ][ ry ] indicating edge offset type of the current coding tree block at position rx and ry for the color component cldx. When sao_eo_class [ cldx ][ rx ][ ry ] is not present, it is inferred as follows.

```
If sao_merge_left_flag is equal to 1, then
         sao_eo_class[ cIdx ][ rx ][ ry ]
is set equal to
         sao_eo_class [ cIdx ][ rx - 1 ][ ry ].
```

```
                    Otherwise, if sao_merge_up_flag is equal to 1, then
                              sao_eo_class[ cIdx ][ rx ][ ry ]
        is set equal to
                              sao_eo_class [ cIdx ][ rx ][ ry - 1 ].
```

Otherwise, sao_merge_up_flag is not equal to 1, whereby sao_eo_class [ cIdx ][ rx ][ ry ] is set equal to 0.

The parameter sao_band_position[ cIdx ][ rx ][ ry ] indicates the displacement of the band offset of the pixel range when

sao_type_idx[ cIdx ][ rx ][ ry ] is equal to 0.

The parameter sao_offset_sign[ cIdx ][ rx ][ ry ][ i ] specifies the sign of sao_offset[ cIdx ][ rx ][ ry ][ i ] when sao_type_index is equal to 0.

The variable offsetSign is derived as follows.

If sao_type_idx[ cIdx ][ rx ][ ry ] is equal to 1 and i is greater than 1, offsetSign is set equal to -1.

Otherwise, if sao_type_idx[ cIdx ][ rx ][ ry ] is equal to 1 and i is less than 2, offsetSign is set equal to 1.

### C. Embodiment C: Type First SAO coding

In this embodiment the coding of SAO type is reconfigured to have separate signaling for SAO On / Off, SAO type BO and EO and EO / BO side information (classes or band positions). The embodiment also groups both context coded bins and by-pass coded bins to improve throughput for context-based adaptive binary arithmetic coding (CABAC).

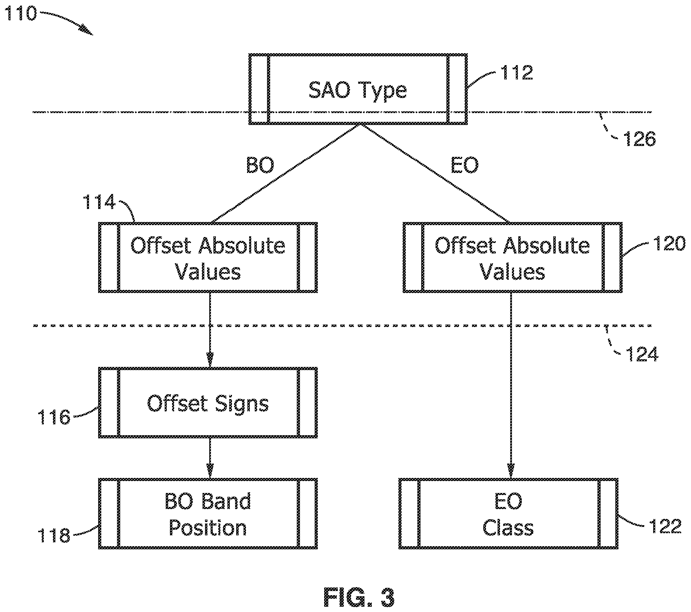

FIG. 3 illustrates an example embodiment 110 of another SAO enhanced signaling mechanism according to the present invention spread across context and bypass coding. Two variations are shown according to which portions are context coded versus by-pass coded. SAO type is selected 112, with absolute values coded for band offset (BO) 114, or alternatively, edge offset (EO) 120. Coding offset signs are passed 116 for BO followed by BO band position 118. For edge offset coding, EO class is sent 122.

Two dashed lines 124, 126 are seen in the flowchart depicting two different separations of context coding (operations seen above the line), versus by-pass coding (operations seen below the line). For example, in one variation the flowchart steps above dashed line 124 represent context coded steps, while steps below line 124 represent steps coded with bypass coding. For example, SAO type 112, and offset absolute values for BO and EO are depicted above line 124, and thus are context coded. The coding of offset signs 116, BO band position 118, and EO class 122, are by-pass coded.

Considering dashed line position 126 seen passing through SAO type block 112, here a portion (e.g., first bin) of the SAO is context coded while the remaining bins are block coded. In either case, it can be seen from the flowchart that embodiment C provides a balanced signaling structure for EO and BO.

Current SAO types (in HEVC WD 7) consist of SAO on / off, 4 Edge Offset (EO) classes, and one Band Offset (BO). These options (SAO types) are signaled to the decoder using a Unary code with two contexts (e.g., CABAC coding), one on the first bin and one for the rest of the bins. In addition, for the BO type, band position is transmitted using FL codes.

The present invention considers that in providing a more regularized structure, the process can be improved in at least four different ways, as outlined. (1) While there are only two actual types in SAO (namely EO and BO), the SAO types in current design consists of 4 EO classes, yet only 1 BO. Therefore, the extra context in CABAC mode cannot track the statistics of EO versus BO. (2) The four EO classes correspond to 4 directions but have very different code lengths. Logically, due to the symmetry in a large-enough set of images, there should not be an advantage to a direction compared to the rest. This has been confirmed even on the HEVC test set which is a much smaller test set. The numbers of occurrences of the four directions are almost uniformly distributed hence FL codes are used. (3) Side information is transmitted only in BO. Side information for the EO classes (directions), however, are coded with SAO type and on/off switch. (4) Context coded bins and by-pass coded bins are interleaved in the current WM 7, because band positions of BO are encoded in by-pass mode before offsets coded with contexts.

In this embodiment of the invention, SAO type is first signaled and side information (i.e., EO classes and BO band position) is signaled separately. This configuration provides a balanced structure, reduced branches and improved throughput. These changes are itemized as follows. (a) The SAO type (sao_type_idx) is reduced to indicate only SAO on / off, BO and EO as shown in Table 14. (b) Parameter sao_type_idx is binarized using truncated unary. In one alternative context modeling is coded with only one context for the first bin and bypass coding for the second bin, or coded with two contexts: one for the first bin and the other for the second bin. (c) EO classes are signaled using sao_eo_class as is the same as that shown in Table 10, which is encoded by FLC with by-pass. (d) Reordering of syntax to avoid interleaving of context coded bins and by-pass coded bins.

These changes operate to reduce the number of context coded bins for SAO syntax (including SAO type and BO/EO information).

The following describes aspects of the SAO parameter semantics which were shown in Table 14. Parameter sao_eo_class[ cldx ][ rx ][ ry ] indicates the edge offset type as specified in Table 15 of current coding tree block at position rx and ry for the color component cldx.

Table 16 provides examples of variable initialization for sao_Type_Idx ctxldx.

Table 17 illustrates syntax and binarization types for selected variables.

**Interleaving Issue.**

In the current HEVC WD7 and JCTVC-I0246, context coded bins and by-pass coded bins are interleaved. This interleaving limits the throughput of the CABAC engine. To resolve the interleaving issue, one element of the present invention reorders the syntax to group each category and have the context coded bin group before the by-pass coded bin group.

Embodiments of the present invention may be described with reference to flowchart illustrations of methods and systems according to embodiments of the invention, as well as algorithms, formulae, or other computational depictions, which may also be implemented as computer program products. In this regard, each block or step of a flowchart, and combinations of blocks (steps, or a combination thereof) in a flowchart, algorithm, formula, or computational depiction can be implemented by various means, such as hardware, firmware, software including one or more computer program instructions embodied in computer-readable program code logic. As will be appreciated, any such computer program instructions may be loaded onto a computer, including without limitation a general purpose computer or special purpose computer, or other programmable processing apparatus to produce a machine, such that the computer program instructions which execute on the computer or other programmable processing apparatus create means for implementing the functions specified in the block(s) of the flowchart(s).

Accordingly, blocks of the flowcharts, algorithms, formulae, or computational depictions support combinations of means for performing the specified functions, combinations of steps for performing the specified functions, and computer program instructions, such as embodied in computer-readable program code logic means, for performing the specified functions. It will also be understood that each block of the flowchart illustrations, algorithms, formulae, or computational depictions and combinations thereof described herein, can be implemented by special purpose hardware-based computer systems which perform the specified functions or steps, or combinations of special purpose hardware and computer-readable program code logic means.

Furthermore, these computer program instructions, such as embodied in computer-readable program code logic, may also be stored in a computer-readable memory that can direct a computer or other programmable processing apparatus to function in a particular manner, such that the instructions stored in the computer-readable memory produce an article of manufacture including instruction means which implement the function specified in the block(s) of the flowchart(s). The computer program instructions may also be loaded onto a computer or other programmable processing apparatus to cause a series of operational steps to be performed on the computer or other programmable processing apparatus to produce a computer-implemented process such that the instructions which execute on the computer or other programmable processing apparatus provide steps for implementing the functions specified in the block(s) of the flowchart(s), algorithm(s), formula(e), or computational depiction(s).

Table 1

| (Prior Art) Mapping of LCU SAO enable flags to a lcu_sao_enable_idx index | | | | |
|---|---|---|---|---|
| LCU SAO enable flag | | | Combination index | Code index (lcu_sao_enable_idx) |
| Y | Cb | Cr | | |
| 0 | 0 | 0 | 0 | 0 |
| 0 | 0 | 1 | 1 | 5 |
| 0 | 1 | 0 | 2 | 6 |
| 0 | 1 | 1 | 3 | 7 |
| 1 | 0 | 0 | 4 | 1 |
| 1 | 0 | 1 | 5 | 2 |
| 1 | 1 | 0 | 6 | 3 |
| 1 | 1 | 1 | 7 | 4 |

Table 2

| (Prior Art) SAO type table in JCTVC-I0193 | |
|---|---|
| **sao_type_idx** | **SAO type** |
| 0 | 1D 0-degree edge |
| 1 | 1D 90-degree edge |
| 2 | 1D 135-degree edge |
| 3 | 1D 45-degree edge |
| 4 | Band |

Table 3

| Embodiment A - Slice Data Syntax with Descriptor | |
|---|---|
| slice_data( ) { | Desc. |
| CtbAddrRS = SliceCtbAddrRS | |
| CtbAddrTS = CtbAddrRStoTS[ CtbAddrRS ] | |
| moreDataFlag = 1 | |
| if( adaptive_loop_filter_flag && alf_cu_control_flag ) | |
| AlfCuFlagIdx = -1 | |
| do { | |
| xCtb = InverseRasterScan( CtbAddrRS, CtbSize, CtbSize, pi_width_in_luma_samples, 0 ) | |
| yCtb = InverseRasterScan( CtbAddrRS, CtbSize, CtbSize, pic_width_in_luma_samples, 1 ) | |
| NumPCMBlock = 0 | |
| CtbAddrInSlice = CtbAddrRS - ( slice_address >> SliceGranularity ) | |
| if( slice_sample_adaptive_offset_flag[ 0 ]) | |
| **lcu_sao_enable_idx** | ae(v) |
| for( cIdx = 0; cIdx < 3; cIdx++ ) { | |
| if( slice_sample_adaptive_offset_flag[ cIdx ] &&LcuSaoEnableFlag [ 0 ][ xCtb ][ yCtb 1) | |
| sao_param( xCtb, yCtb, cIdx ) | |
| } | |
| moreDataFlag = coding_tree( xCtb, yCtb, Log2CtbSize, 0 ) | |
| CtbAddrTS++ | |
| CtbAddrRS = CtbAddrTStoRS[ CtbAddrTS ] | |
| if( moreDataFlag && ( ( tiles_or_entropy_coding_sync_idc = = 1 && TileId[ CtbAddrTS ] != TileId[ CtbAddrTS - 1 ]) \|\| (tiles_or_entropy_coding_sync_idc = = 2 && CtbAddrTS % PicWidthInCtbs == 0 ) ) ) | |
| rbsp_alignment( ) | |
| } while( moreDataFlag ) | |
| } | |

Table 4

| Embodiment A: SAO Parameter Syntax with Descriptor | |
|---|---|
| sao_param( rx, ry, cldx ){ | **Desc.** |
| if( rx > 0 ) { | |
| leftCtbInSlice = CtbAddrInSlice > 0 | |
| leftCtbInTile = TileId[ CtbAddrTS ] = = TileId[ CtbAddrRStoTS[ CtbAddrRS - 1 ] ] | |
| if( leftCtbInSlice && leftCtbInTile&& LcuSaoEnableFlag[ cldx ][ rx - 1][ ry ] ) | |
| **sao_merge_left_flag** | ae(v) |
| } | |
| if( ry > 0 && !sao_merge_left_flag ) { | |
| upCtbInSlice = (CtbAddrTS - CtbAddrRStoTS[CtbAddrRS - PicWidthInCtbs]) <= CtbAddrInSlice | |
| upCtbInTile = TileId[ CtbAddrTS ] = = TileId[ CtbAddrRStoTS[ CtbAddrRS-PicWidthInCtbs ] ] | |
| **if( upCtbInSlice &&** upCtbInTile&& LcuSaoEnableFlag[ cldx ][ rx - 1][ ry ] ) | |
| **sao_merge_up_flag** | ae(v) |
| } | |
| if( !sao_merge_up_flag && !sao_merge_left_flag&& LcuSaoEnableFlag[ cldx ][ rx ][ ry ] ) { | |
| **sao_type_idx[** cldx ][ rx ][ ry ] | ae(v) |
| if( sao_type_idx[ cldx ][ rx ][ ry ] = =5 ) | |
| **sao_band_position[** cldx ][ rx ][ ry ] | ae(v) |
| if( sao_type_idx[ cldx ][ rx ][ ry ] != 0 ) | |
| for( i = 0; i < 4; i++ ) | |
| **sao_offset_abs[** cldx ][ rx][ ry ][ i ] | ae(v) |
| if( sao_type_idx[ cldx ][ rx ][ ry ] = = 5 ) { | |
| for( i = 0; i < 4; i++ ) { | |
| if( sao_offset_abs[ cldx ][ rx ][ ry ] != 0 ) | |
| **sao_offset_sign[** cldx ][ rx ][ ry ][ i ] | ae(v) |
| } | |
| } | |
| } | |
| } | |

Table 5

| Embodiment A: Specifying SAO Type | |
|---|---|
| **sao_type_idx[ cldx ][ rx ][ ry ]** | **SAO type (informative)** |
| 0 | 1D 0-degree edge offset |
| 1 | 1D 90-degree edge offset |
| 2 | 1D 135-degree edge offset |

(continued)

| Embodiment A: Specifying SAO Type | |
|---|---|
| **sao_type_idx[ cldx ][ rx ][ ry ]** | **SAO type (informative)** |
| 3 | 1D 45-degree edge offset |
| 4 | Band offset |

Table 6

| Embodiment A: Specifying SAO Slice Data Semantics | | | |
|---|---|---|---|
| **lcu_sao_enable_i dx** | LcuSaoEnableFlag[ cldx ][ rx ][ ry ] | | |
| | cldx = 0 | cldx = 1 | cldx = 2 |
| 0 | 0 | 0 | 0 |
| 1 | 1 | 0 | 0 |
| 2 | 0 | 1 | 0 |
| 3 | 1 | 1 | 0 |
| 4 | 0 | 0 | 1 |
| 5 | 1 | 0 | 1 |
| 6 | 0 | 1 | 1 |
| 7 | 1 | 1 | 1 |

Table 7

| Embodiment B: SAO Types in JCTVC-J0268 + simplfied JCTVC-I0193 | |
|---|---|
| **sao_type_idx[cldx][rx][ry ]** | **SAO type (informative)** |
| 0 | Band Offset (BO) |
| 1 | Edge Offset (EO) |

Table 8

| Embodiment B: SAO Edge Offset Class | |
|---|---|
| **sao_type_idx [cldx][rx][ry]** | **SAO EO Class** |
| 0 | 1D 0-degree edge |
| 1 | 1D 90-degree edge |
| 2 | 1D 135-degree edge |
| 3 | 1D 45-degree edge |

Table 9

| Embodiment B: Specification of Slice Data Syntax | |
|---|---|
| slice_data( ) { | **Descriptor** |
|     CtbAddrRS = SliceCtbAddrRS | |
|     CtbAddrTS = CtbAddrRStoTS[ CtbAddrRS ] | |

(continued)

| Embodiment B: Specification of Slice Data Syntax | |
|---|---|
| moreDataFlag = 1 | |
| if( adaptive_loop_filter_flag && alf_cu_control_flag ) | |
|     AlfCuFlagIdx = -1 | |
| do { | |
|     xCtb = InverseRasterScan( CtbAddrRS, CtbSize, CtbSize, pic_width_in_luma_samples, 0 ) | |
|     yCtb = InverseRasterScan( CtbAddrRS, CtbSize, CtbSize, pic_width_in_luma_samples, 1 ) | |
|     NumPCMBlock = 0 | |
|     CtbAddrInSlice = CtbAddrRS - ( slice_address » SliceGranularity ) | |
|     if( slice_sample_adaptive_offset_flag[ 0 ]) | |
|         **lcu_sao_enable_idx** | ae(v) |
|     for( cIdx = 0; cIdx < 3; cIdx++ ) { | |
|         if( slice_sample_adaptive_offset_flag[ cIdx ] &&LcuSaoEnableFlag[ 0 ][ xCtb ][ yCtb ]) | |
|             sao_param( xCtb, yCtb, cIdx ) | |
|     } | |
|     moreDataFlag = coding_tree( xCtb, yCtb, Log2CtbSize, 0 ) | |
|     CtbAddrTS++ | |
|     CtbAddrRS = CtbAddrTStoRS[ CtbAddrTS ] | |
|     if( moreDataFlag && ((tiles_or_entropy_coding_sync_idc = = 1 && TileId[ CtbAddrTS ] != TileId[ CtbAddrTS - 1 ] ) \|\| (tiles_or_entropy_coding_sync_idc = = 2 && CtbAddrTS % PicWidthInCtbs = = 0 ))) | |
|         rbsp_alignment( ) | |
|   } while( moreDataFlag ) | |
| } | |

Table 10

| Embodiment B: SAO Parameter Syntax | |
|---|---|
| sao_param( rx, ry, cIdx ){ | **Descriptor** |
|     if( rx > 0 ) { | |
|         leftCtbInSlice = CtbAddrInSlice > 0 | |
|         leftCtbInTile = TileId[ CtbAddrTS ] = = TileId[ CtbAddrRStoTS[ CtbAddrRS - 1 ] ] | |
|         if( leftCtbInSlice && leftCtbInTile&& LcuSaoEnableFlag[ cIdx ][ rx - 1][ ry ] ) | |
|             **sao_merge_left_flag** | ae(v) |
|     } | |
|     if( ry > 0 && !sao_merge_left_flag ) { | |

(continued)

| Embodiment B: SAO Parameter Syntax | |
|---|---|
| upCtbInSlice = (CtbAddrTS - CtbAddrRStoTS[CtbAddrRS - PicWidthInCtbs]) <= CtbAddrInSlice | |
| upCtbInTile = TileId[ CtbAddrTS ] = = TileId[ CtbAddrRStoTS[ CtbAddrRS - PicWidthInCtbs ] ] | |
| if( upCtbInSlice && upCtbInTile&& LcuSaoEnableFlag[ cldx ][ rx - 1][ ry ] ) | |
| **sao_merge_up_flag** | ae(v) |
| } | |
| if( !sao_merge_up_flag && !sao_merge_left_flag&& LcuSaoEnableFlag[ cldx ][ rx ][ ry ] ) { | |
| **sao_type_idx**[ cldx ][ rx ][ ry ] | ae(v) |
| if( sao_type_idx[ cldx ][ rx ][ ry ] != 0 ) | |
| for( i = 0; i < 4; i++ ) | |
| **sao_offset_abs**[ cldx ][ rx][ ry ][ i ] | ae(v) |
| if( sao_type_idx[ cldx ][ rx ][ ry ] = = 5 ) { | |
| for( i = 0; i < 4; i++ ) { | |
| if( sao_offset_abs[ cldx ][ rx ][ ry ] != 0 ) | |
| **sao_offset_sign** [ cldx ][ rx ][ ry ][ i ] | ae(v) |
| } | |
| } | |
| **sao_band_position**[ cldx ][ rx ][ ry ] | ae(v) |
| } | |
| else | |
| **sao_eo_class**[ cldx ][ rx ][ ry ] | ae(v) |
| } | |
| } | |

Table 11

| Embodiment B: Specification of SAO Type | |
|---|---|
| **sao_type_idx[ cldx ][ rx ][ ry ]** | **SAO type (informative)** |
| 0 | Band offset |
| 1 | Edge offset |

Table 12

| Embodiment B: Specification of LcuSaoEnableFlag for Three Color Components | | | |
|---|---|---|---|
| **lcu_sao_enable_i dx** | LcuSaoEnableFlag[ cldx ][ rx ][ ry ] | | |
| | cldx = 0 | cldx = 1 | cldx = 2 |
| 0 | 0 | 0 | 0 |
| 1 | 1 | 0 | 0 |

(continued)

| Embodiment B: Specification of LcuSaoEnableFlag for Three Color Components | | | |
|---|---|---|---|
| lcu_sao_enable_i dx | LcuSaoEnableFlag[ cldx ][ rx ][ ry ] | | |
| | cldx = 0 | cldx = 1 | cldx = 2 |
| 2 | 0 | 1 | 0 |
| 3 | 1 | 1 | 0 |
| 4 | 0 | 0 | 1 |
| 5 | 1 | 0 | 1 |
| 6 | 0 | 1 | 1 |
| 7 | 1 | 1 | 1 |

Table 13

| Embodiment B: Specification of hPos and vPos for SAO | | | | |
|---|---|---|---|---|
| sao_eo_class[ cldx ][ rx ][ ry ] | 0 | 1 | 2 | 3 |
| hPos[0] | -1 | | 0 -1 | 1 |
| hPos[1] | 1 | 0 | 1 | -1 |
| vPos[0] | 0 | -1 | -1 | -1 |
| vPos[1] | 0 | 1 | 1 | 1 |

Table 14

| Embodiment C: Specification of SAO Type | |
|---|---|
| sao_type_idx[ cldx ][ rx ][ ry ] | SAO type (informative) |
| 0 | Not applied |
| 1 | Band offset |
| 2 | Edge offset |

Table 15

| Embodiment C: Specification of SAO Edge Offset Class | |
|---|---|
| sao_eo_class [ cldx ][ rx ][ ry ] (i | SAO edge offset class nformative) |
| 0 | 1D 0-degree edge offset |
| 1 | 1D 90-degree edge offset |
| 2 | 1D 135-degree edge offset |
| 3 | 1D 45-degree edge offset |

Table 16

| Embodiment C: Examples of Variable initValue for sao_type_idxldx | | | | | | |
|---|---|---|---|---|---|---|
| Init | sao_type_idx ctxldx | | | | | |
| variable | 0 | 1 | 2 | 3 | 4 | 5 |

(continued)

| Embodiment C: Examples of Variable initValue for sao_type_idxldx | | | | | | |
|---|---|---|---|---|---|---|
| **Init** | **sao_type_idx ctxldx** | | | | | |
| **initValue** | 200 | 157 | 185 | 157 | 160 | 157 |

Table 17

| Embodiment C: Syntax and Binarization Types for Select Variables | | | | | |
|---|---|---|---|---|---|
| **Syntax element** | **initType** | **Type of binarization** | **maxBinld xCtx** | **ctxldxTab le** | **ctxldxOff set** |
| sao_type_idx | 0 | TU, cMax = 2 | 1 | Table 16 | 0 |
| | 1 | | 1 | Table 16 | 2 |
| | 2 | | 1 | Table 16 | 4 |
| sao_eo_class | 0 | FL, cMax = 2 | - na - | - na - | - na - * |
| | 1 | | - na - | - na - | - na - * |
| | 2 | | - na - | - na - | - na - * |
| * -- uses Decode Bypass | | | | | |

## Claims

1. An apparatus for sample adaptive offset "SAO" signaling during entropy encoding of a video, the apparatus comprising:

   (a) a video encoder having a processor; and
   (b) programming executable on said processor and configured for:

   (i) receiving a decoded video signal from a deblocking filter after inverse quantization and inverse transform operations in the video encoder;
   (ii) indicating within a two-bit syntax element SAO type only, wherein the SAO type comprises one of SAO on / off, band offset "BO" and edge offset "EO";
   (iii) binarizing SAO type using truncated unary;
   (iv) coding offset absolute values for BO, or alternatively coding offset absolute values for EO, depending on whether SAO type is BO or EO;
   (v) coding offset signs for BO followed by coding BO band, indicating a displacement of the band offset, or alternatively coding EO class as one of four classes indicating direction, depending on whether SAO type is BO or EO;
   (vi) signaling said SAO type to a decoder;
   (vii) signaling offset absolute values for BO, or alternatively signaling offset absolute values for EO, to the decoder depending on whether SAO type is BO or EO; and
   (viii) signaling offset signs for BO followed by signaling BO band, or alternatively signaling EO class, to the decoder depending on whether SAO type is BO or EO;

   wherein said SAO type, BO offset absolute value, EO offset absolute value, BO offset signs, BO band position, and EO class are signaled using a syntax in which a first bin of SAO type is context coded while remaining bins signaled for SAO type, BO offset absolute value, EO offset absolute value, BO offset signs, BO band position, and EO class are by-pass coded, the programming executable on said processor being configured for ordering the syntax to group the context-coded bins of the syntax before the by-pass coded bins of the syntax.

2. The apparatus recited in claim 1, wherein said apparatus operates according to a High Efficiency Video Coding (HEVC) standard.

3. The apparatus recited in claim 1, wherein said apparatus requires only one band offset (BO) type.

4. The apparatus recited in claim 1, wherein said programming is configured for transmitting thirty-two possible BO bands for a first non-zero band.

5. The apparatus recited in claim 1, wherein said programming is configured for performing context-adaptive binary arithmetic coding.

**Patentansprüche**

1. Vorrichtung zur Sample-Adaptiv-Offset- bzw. "SAO"-Signalisierung während Entropie-Codierung eines Videos, wobei die Vorrichtung Folgendes umfasst:

   (a) einen Videocodierer mit einem Prozessor; und
   (b) auf dem Prozessor ausführbare Programmierung, ausgelegt zum:

   (i) Empfangen eines decodierten Videosignals von einem Entblockungsfilter nach Invers-Quantisierung und Invers-Transformationsoperationen in dem Videocodierer;
   (ii) Angabe nur in einem Zwei-Bit-Syntaxelement-SAO-Typ, wobei der SAO-Typ SAO-Ein/Aus, Bandoffset "BO" oder Randoffset "EO" umfasst;
   (iii) Binärisieren des SAO-Typs unter Verwendung von abgeschnittenem Unär;
   (iv) Codieren von Offset-Absolutwerten für BO oder als Alternative Codieren von Offset-Absolutwerten für EO abhängig davon, ob der SAO-Typ BO oder EO ist;
   (v) Codieren von Offset-Vorzeichen für BO, gefolgt von Codierung des BO-Bands, Angabe einer Verschiebung des Band-Offsets oder als Alternative Codieren der EO-Klasse als eine von vier Klassen, wodurch Richtung angegeben wird, abhängig davon, ob der SAO-Typ BO oder EO ist;
   (vi) einem Decodierer den SAO-Typ signalisieren;
   (vii) dem Decodierer Offset-Absolutwerte für BO signalisieren oder als Alternative Offset-Absolutwerte für EO signalisieren, abhängig davon, ob der SAO-Typ BO oder EO ist; und
   (viii) dem Decodierer Offset-Vorzeichen für BO signalisieren, gefolgt von Signalisieren des BO-Bands, oder als Alternative EO-Klasse signalisieren, abhängig davon, ob der SAO-Typ BO oder EO ist;

   wobei der SAO-Typ, der BO-Offset-Absolutwert, der EO-Offset-Absolutwert, die BO-Offset-Vorzeichen, die BO-Bandposition und die EO-Klasse unter Verwendung eines Syntax signalisiert werden, bei der ein erstes Bin des SAO-Typs kontextcodiert wird, während übrige für den SAO-Typ, den BO-Offset-Absolutwert, den EO-Offset-Absolutwert, BO-Offset-Vorzeichen, BO-Bandposition und EO-Klasse signalisierte Bins bypass-codiert werden, wobei die auf dem Prozessor ausführbare Programmierung ausgelegt ist zum Ordnen der Syntax, um die kontextcodierten Bins der Syntax vor den bypasscodierten Bins der Syntax zu gruppieren.

2. Vorrichtung nach Anspruch 1, wobei die Vorrichtung gemäß einem HEVC-Standard (High Efficiency Video Coding) arbeitet.

3. Vorrichtung nach Anspruch 1, wobei die Vorrichtung nur einen Bandoffset- bzw. BO-Typ benötigt.

4. Vorrichtung nach Anspruch 1, wobei die Programmierung dafür ausgelegt ist, zweiunddreißig mögliche BO-Bänder für ein erstes von null verschiedenes Band zu übertragen.

5. Vorrichtung nach Anspruch 1, wobei die Programmierung dafür ausgelegt ist, kontext-adaptive binär-arithmetische Codierung durchzuführen.

**Revendications**

1. Appareil de signalisation de décalage adaptatif d'échantillon "SAO" lors d'un codage entropique d'une vidéo, l'appareil comprenant :

   (a) un codeur vidéo doté d'un processeur ; et

(b) une programmation exécutable sur ledit processeur et configurée pour :

(i) recevoir un signal vidéo décodé à partir d'un filtre de déblocage après des opérations de quantification inverse et de transformation inverse dans le codeur vidéo ;

(ii) indiquer dans un élément de syntaxe à deux bits uniquement le type de SAO, le type de SAO comprenant : SAO actif/inactif, décalage de bande "BO" ou décalage de bord "EO" ;

(iii) binarisation du type de SAO à l'aide d'un unaire tronqué ;

(iv) codage de valeurs absolues de décalage pour BO, ou alternativement codage de valeurs absolues de décalage pour EO, selon que le type de SAO est BO ou EO ;

(v) codage de signes de décalage pour BO suivi d'un codage de bande BO, indiquant un déplacement du décalage de bande, ou alternativement codage de classe EO comme l'une de quatre classes indiquant une direction, selon que le type de SAO est BO ou EO ;

(vi) signalisation dudit type de SAO à un décodeur ;

(vii) signalisation de valeurs absolues de décalage pour BO, ou alternativement de valeurs absolues de décalage pour EO, au décodeur selon que le type de SAO est BO ou EO ; et

(viii) signalisation de signes de décalage pour BO suivie d'une signalisation de bande BO, ou alternativement signalisation de classe EO, au décodeur selon que le type de SAO est BO ou EO ;

dans lequel lesdits type de SAO, valeur absolue de décalage BO, valeur absolue de décalage EO, signes de décalage BO, position de bande BO et classe EO sont signalés à l'aide d'une syntaxe dans laquelle un premier compartiment de type de SAO est codé en contexte tandis que les compartiments restants signalés pour les type de SAO, valeur absolue de décalage BO, valeur absolue de décalage EO, signes de décalage BO, position de bande BO et classe EO sont codés en dérivation, la programmation exécutable sur ledit processeur étant configurée pour ordonner la syntaxe afin de regrouper les compartiments codés en contexte de la syntaxe avant les compartiments codés en dérivation de la syntaxe.

2. Appareil selon la revendication 1, ledit appareil fonctionnant selon une norme de codage vidéo de haute efficacité (HEVC).

3. Appareil selon la revendication 1, ledit appareil ne nécessitant qu'un seul type de décalage de bande (BO).

4. Appareil selon la revendication 1, dans lequel ladite programmation est configurée pour transmettre trente-deux bandes BO possibles pour une première bande non nulle.

5. Appareil selon dans la revendication 1, dans lequel ladite programmation est configurée pour réaliser un codage arithmétique binaire adaptatif au contexte.

**FIG. 1**

EP 2 853 033 B1

**FIG. 2**

EP 2 853 033 B1

**FIG. 3**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MAANI et al.** SAO Type Coding Simplification. *JCTVC-I0246,* April 2012